# EUROPEAN PATENT APPLICATION

(11) **EP 3 379 714 A1**
(43) Date of publication of application: **26.09.2018**
(21) Application number: 16866056.1
(22) Date of filing: 07.10.2016
(51) Int. Cl.: H02M 7/48, H01L 25/18, H02P 27/06

(54) **SYSTEM-IN-PACKAGE AND MOTOR DRIVE CIRCUIT DEVICE**

(30) Priority: 17.11.2015 JP 2015224653
(71) Applicant: Nidec Corporation, Kyoto-shi, Kyoto 601-8205 (JP)
(72) Inventor: MATSUZAKI, Kazuya, Kyoto-shi Kyoto 601-8205 (JP); UE, Kazumasa, Kyoto-shi Kyoto 601-8205 (JP); NAKAMARU, Yuji, Kyoto-shi Kyoto 601-8205 (JP)
(74) Representative: Stöckeler, Ferdinand
(86) International application number: PCT/JP2016/080032
(87) International publication number: WO 2017/086054

(57) **Abstract**

[Abstract] A system in package usable by being connected to an inverter output circuit includes an analog circuit chip including gate driver circuits that output gate drive signals for controlling switching operation of the inverter output circuit to a terminal electrode and a computer chip including a memory where a motor control program is stored. It is possible to switch between a first mode in which a potential variation range of the gate drive signal for controlling a switching operation of a high-side transistor is set to be identical to a potential variation range of the gate drive signal for controlling a switching operation of a low-side transistor irrespective of a potential of a connection node between the high-side transistor and the high-side transistor in the inverter output circuit and a second mode in which the potential variation range of the gate drive signal for controlling the switching operation of the high-side transistor is changed in accordance with a potential of a connection node of the inverter output circuit.

## Description

### Technical Field

The present application relates to a system in package that may be preferably used in a motor drive circuit, and a motor drive circuit device including the system in package. In addition, the present application also relates to a motor module including a motor and the motor drive circuit device.

### Background Art

Motors such as a brushless DC motor and an alternating current synchronous motor are driven by three-phase current. To accurately control waveforms of the three-phase current, a complex control technique such as vector control is used. In such control technique, an advanced mathematical operation is needed, and a digital operating circuit such as a micro controller (microcontroller) is used. The vector control technique is applied for uses where load fluctuation of the motor is large in fields such as, for example, washing machines, electric-powered assist bicycles, electric-powered scooters, electric-powered power steering, electric automobiles, and industrial equipment. On the other hand, a different motor control system is adopted for a motor where an output is relatively small.

Up to now, a control circuit of the motor has been manufactured while various circuit parts such as a microcontroller, a gate driver circuit, an operational amplifier, and a DC-DC converter are appropriately combined for the motor.

PTL 1 discloses a technique to integrate, as a peripheral circuit that controls an inverter, a gate signal generation circuit and a gate driver circuit on a single semiconductor integrated circuit chip (a single semiconductor substrate).

### Citation List

### Patent Literature

PTL 1: Japanese Unexamined Patent Application Publication No. 2010-187435

### Summary of Invention

### Technical Problem

Parts such as a microcontroller for control, a gate driver circuit, an operational amplifier, and a DC-DC converter are appropriately selected in accordance with a type and a size of a motor and individually evaluated, and then it is necessary to mount these parts on a single circuit substrate. Thus, as uses of the motor increase, the number of types of necessary electronic parts increases, and an issue occurs that costs in development and manufacturing of a motor drive circuit device may increase. There is not much difference in situations even when the semiconductor integrated circuit chip disclosed in PTL 1 is used.

Embodiments of a system in package and a motor drive circuit device in the present disclosure can solve the above-mentioned issue.

### Solution to Problem

An exemplified system in package in the present disclosure is used by being connected to an inverter output circuit that includes plural pairs each including a high-side transistor and a low-si.de transistor connected in series and generates motor drive voltages of a plurality of phases each of which is generated from a connection node between the high-side transistor and the low-side transistor in a corresponding pair. The system in package according to an embodiment includes a support including a plurality of terminal electrodes, an analog circuit chip that is electrically connected to a first terminal electrode group included in the plurality of terminal electrodes and includes a plurality of gate driver circuits that output gate drive signals for controlling respective switching operations of the high-side transistors and the low-side transistors to any one of the terminal electrodes of the first terminal electrode group, and a computer chip that is electrically connected to a second terminal electrode group included in the plurality of terminal electrodes and the analog circuit chip and includes a memory in which a motor control program is stored. It is possible to switch between a first mode in which a potential variation range of the gate drive signal for controlling the switching operation of the high-side transistor is set to be identical to a potential variation range of the gate drive signal for controlling the switching operation of the low-side transistor irrespective of a potential of the connection node of the inverter output circuit and a second mode in which the potential variation range of the gate drive signal for controlling the switching operation of the high-side transistor is changed in accordance with the potential of the connection node of the inverter output circuit. Advantageous Effects of Invention

With the system in package according to the embodiment of the present disclosure, various types of motor control can be realized by one system in package by changing the program stored in the memory. In addition, since the operation can be performed by switching between the two different modes, when necessary, another gate driver circuit having a higher breakdown voltage selected in accordance with an output of a motor, instead of the gate driver circuit included in the analog circuit chip, can also be operated by being connected between the system in package and the motor. According to the present disclosure, since highly versatile usage can be realized by one system in package, it is possible to realize reduction in manufacturing costs due to expansion of a mass production scale.

### Brief Description of Drawings

[Fig. 1] Fig. 1 illustrates an exemplary configuration of a motor circuit of the related art.
[Fig. 2] Fig. 2 illustrates an exemplary configuration of a non-restrictive illustrative embodiment of a system in package (SiP) in the present disclosure. Fig. 2 illustrates an exemplary configuration of a motor circuit of the related art.
[Fig. 3] Fig. 3 illustrates an exemplary configuration of an inverter output circuit 300.
[Fig. 4A] Fig. 4A is a perspective view of a top surface of a SiP 100 according to the present embodiment as viewed obliquely downward.
[Fig. 4B] Fig. 4B is a perspective view of a bottom surface of the SiP 100 according to the present embodiment as viewed obliquely downward.
[Fig. 5] Fig. 5 illustrates a more specific exemplary configuration of the SiP 100 according to the embodiment of the present disclosure.
[Fig. 6] Fig. 6 illustrates the SiP 100 according to
the embodiment of the present disclosure being connected to directly drive respective power transistors of the inverter output circuit 300 and used.
[Fig. 7] Fig. 7 extracts and describes a U-phase output portion 31 and a gate driver circuit 41 in the inverter output circuit 300.
[Fig. 8] Fig. 8 is a circuit diagram describing details of the gate driver circuit 41 in Fig. 7.
[Fig. 9] Fig. 9 is an equivalent circuit diagram illustrating exemplary configurations of a high-side gate power source 45A and a low-side gate power source 45B.
[Fig. 10] Fig. 10 is an equivalent circuit diagram illustrating other exemplary configurations of the high-side gate power source 45A and the low-side gate power source 45B.
[Fig. 11] Fig. 11 illustrates a motor drive circuit device 400 according to an example in which a gate driver circuit different from gate driver circuits 41, 42, and 43 incorporated in the SiP 100 is used to drive a gate of the inverter output circuit 300.
[Fig. 12] Fig. 12 schematically illustrates that the SiP 100 according to the present embodiment may be used by being connected to either one of power modules 300A and 300B including different inverter output circuits.
[Fig. 13] Fig. 13 illustrates an example in which the SiP 100 is connected to a power module 300 having no gate driver circuit incorporated via an external gate driver circuit.

### Description of Embodiments

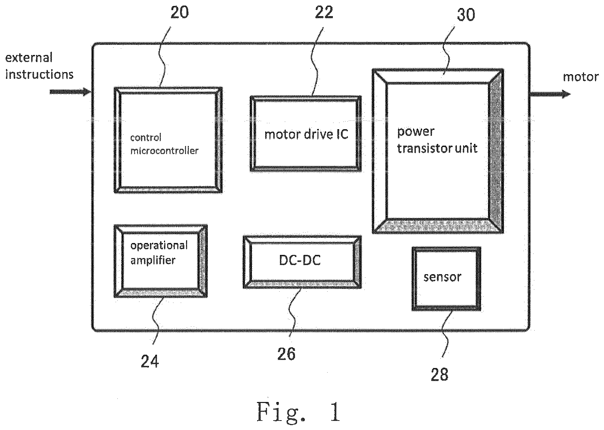

Fig. 1 illustrates an exemplary configuration of a motor circuit of the related art. For simplicity, descriptions of electronic parts such as a power source, a chip resistance, and a chip capacitor are omitted in Fig. 1, and main electronic parts are described in a trial manner. Up to now, it is necessary to design a motor circuit by selecting appropriate parts from among a large number of usable electronic parts in accordance with a type and a use of a motor to be used. The electronic parts exemplified in Fig. 1 are a control microcontroller 20, a motor drive IC 22, an operational amplifier 24, a DC-DC converter 26, a sensor 28 such as a Hall IC, and a power transistor unit 30. The power transistor unit 30 is typically a bridge circuit of a switching element that realizes an inverter output circuit. The switching element constituting the bridge circuit is, for example, a Metal-Oxide-Semiconductor Field-Effect Transistor (MOSFET) or an Insulated Gate Bipolar Transistor (IGBT).

In recent years, Intelligent Power Module (IPM) in which the power transistor unit 30 and a gate drive circuit are mounted in one casing is used in some cases.

In this manner, a large number of electronic parts are used, and in addition, various types of products exist in accordance with sizes of voltage and current to be used and other characteristics even for electronic parts of the same type. A motor drive circuit device constituted by appropriately combining these electronic parts receives external instructions including a rotating direction instruction and a speed instruction and outputs a motor drive voltage in conformity to these external instructions. Such external instructions are issued from a higher-order host computer or the like.

A system in package (hereinafter abbreviated as "SiP") in the present disclosure is a packaged part of a semiconductor integrated circuit element to be used by being connected to an inverter output circuit that drives a motor. In general, the SiP is an electronic part in which a plurality of semiconductor integrated circuit chips is installed in one package and sealed by resin (plastic).

The SiP in the present disclosure includes a computer chip including a memory in which a motor control program is stored and an analog circuit chip, and these chips are mounted in the same package. In the present specification, the computer chip means a monolithic electronic element in which a semiconductor integrated circuit that executes digital signal processing is formed on a semiconductor substrate. The analog circuit chip means a monolithic electronic element in which an analog circuit is formed on a semiconductor substrate. The analog circuit chip in the SiP in the present disclosure generates a signal for directly or indirectly driving a switching element (transistor) of the inverter output circuit. According to the SiP, it is possible to cope with control on various motors of different types by changing the program stored in the memory of the computer chip and the setting of an external constant. Therefore, according to the embodiment of the present disclosure, the number of types and the number of development processes of the necessary electronic parts can be reduced as a whole, and it becomes possible to provide motor drive circuit devices of various types corresponding to various needs at low manufacturing costs.

The program stored in the memory is not limited to a program for vector control and may be any motor control program based on, for example, Open-Loop, PWM (Pulse Width Modulation) drive, PLL (Phase Locked Loop) speed control, sine-wave drive, sensor-less drive, or stepping drive.

When control software becomes further complicated and the amount of memory is not sufficient with a memory circuit alone in the computer chip in the future, a type of product in which a memory chip is mounted in the SiP may also be prepared.

### (Embodiment)

Hereinafter, an embodiment of the present disclosure will be described in detail with reference to the drawings appropriately. It should be noted that detailed descriptions beyond necessity may be omitted in some cases. For example, detailed descriptions of an already well-known item and duplicated descriptions with respect to substantially the same configuration may be omitted in some cases. This is because a situation where the following explanations become unnecessary redundant is avoided to facilitate understanding of those skilled in the art.

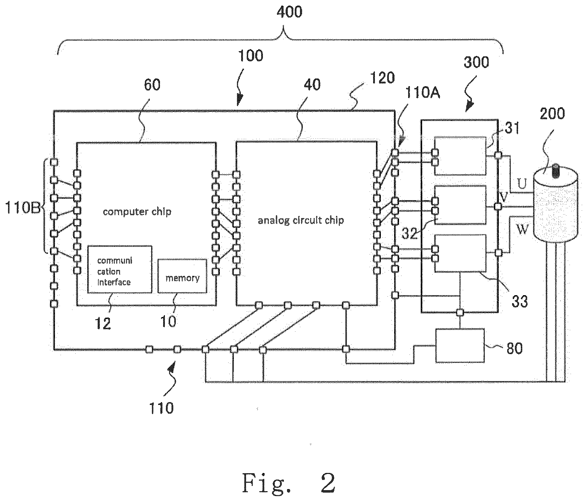

Fig. 2 illustrates an exemplary configuration of a non-restrictive illustrative embodiment of the system in package (SiP) in the present disclosure. Fig. 2 schematically illustrates an inverter output circuit (inverter main circuit) 300 constituting the motor drive circuit device 400 together with a SiP 100, and a motor 200 connected to the motor drive circuit device 400. In the present specification, a system including the motor drive circuit device and the motor will be referred to as a motor module as a whole.

The SiP 100 illustrated in the drawing includes an analog circuit chip 40 and a computer chip 60. The SiP 100 is used by being connected to the inverter output circuit 300 that drives the motor 200. As will be described below, another circuit element or circuit may be connected between the SiP 100 and the inverter output circuit 300.

The motor 200 according to the present embodiment includes a plurality of coils through which three-phase alternating currents flow. The motor 200 is typically a synchronous motor of a permanent-magnet type but may also be a motor of another type. According to the embodiment of the present disclosure, a type, a structure, and a size of the motor 200 that may be used are not particularly limited. It is sufficient when the inverter output circuit 300 has a known configuration selected in accordance with the motor 200. The motor module according to the embodiment of the present disclosure may also include other circuit elements which are not illustrated in the drawing. The SiP 100, the inverter output circuit 300, and other circuits (not illustrated) are used by being mounted to a substrate such as, for example, a printed-circuit board.

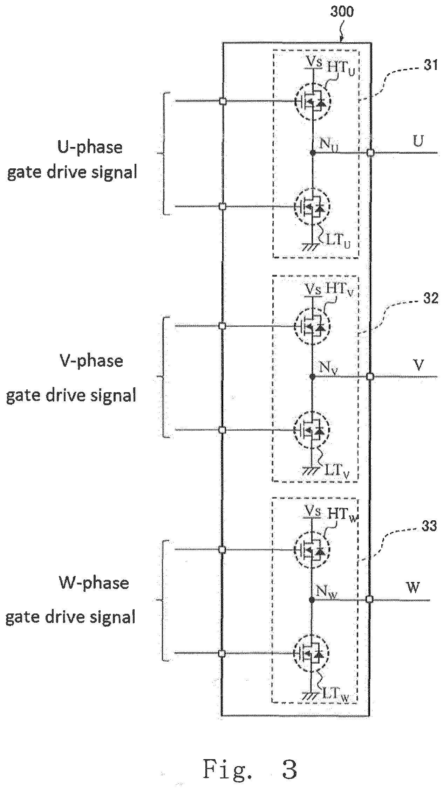

Fig. 3 illustrates an exemplary configuration of the inverter output circuit 300, and this inverter output circuit 300 includes three output portions 31, 32, and 33 and outputs three-phase motor drive voltages constituted by a U phase, a V phase, and a W phase. The inverter output circuit 300 is also referred to as a main circuit of the inverter, a power device portion, or a bridge circuit in some cases. Details will be further described. The motor drive voltage of the U phase is output from a connection node N_{U} between a high-side transistor HT_{U} and a low-side transistor LT_{U} connected in series in the output portion 31. The motor drive voltage of the V phase is output from a connection node N_{V} between a high-side transistor HT_{V} and a low-side transistor LT_{V} connected in series in the output portion 32. The motor drive voltage of the W phase is output from a connection node N_{W} between a high-side transistor HT_{W} and a low-side transistor LT_{W} connected in series in the output portion 33. Each of these transistors (three-terminal switching elements) is a high breakdown voltage power transistor. The power transistor according to the present embodiment illustrated in the drawing is an MOSFET to which a freewheeling diode is connected. The freewheeling diode may be a parasitic diode incorporated in the MOSFET. An IGBT may be used instead of the MOSFET.

A power source voltage V_{S} is supplied to each of drains of the high-side transistors HT_{U}, HT_{V}, and HT_{W}. On the other hand, sources of the low-side transistors LT_{U}, LT_{V}, and LT_{W} are grounded. Sources of the high-side transistors HT_{U}, HT_{V}, and HT_{W} are respectively connected to drains of the low-side transistors LT_{U}, LT_{V}, and LT_{W} via the nodes N_{U}, N_{V}, and N_{W}. In the example disclosed in the present specification, any of the power transistors is constituted by an N-type transistor, but an N-type transistor and a P-type transistor may be combined and used.

A conductive or non-conductive state of each power transistor changes in response to a gate drive signal for controlling a switching operation of the inverter output circuit 300. As a result, the motor drive voltages of the three phases of U, V, and V respectively swing between the power source voltage V_{S} and an earth voltage (0 V) in different phases. For example, when the high-side transistor HT_{U} turns on and the low-side transistor LT_{U} turns off in the U-phase output portion, a potential of the node N_{U} approximately indicates a size of the power source voltage V_{S}. When the high-side transistor HT_{U} turns off and the low-side transistor LT_{U} turns on, the potential of the node N_{U} approximately indicates a size of a ground level (0 V). The same also applies to the V-phase and W-phase output portions. When gate drive signals having appropriate waveforms are supplied to respective gate terminals of the high-side transistors HT_{U}, HT_{V}, and HT_{W} and the low-side transistors LT_{U}, LT_{V}, and LT_{W}, it becomes possible to control the motor 200 by supplying three-phase sine-wave current having the appropriate waveforms to the motor 200.

The power source voltage V_{S} supplied to the inverter output circuit 300 is set at a level at which a current necessary for the motor drive flows through the motor. Thus, a size of the power source voltage V_{S} largely varies in accordance with the type and the use of the motor. A breakdown voltage of the transistors constituting the inverter output circuit 300 is set in accordance with the size of the power source voltage V_{S}. For example, when the high-side transistor HT_{U} turns on and the low-side transistor LT_{U} turns off, a voltage of a size close to the power source voltage V_{S} is applied between the source and the drain of the low-side transistor LT_{U}. Accordingly, the inverter output circuit 300 needs to be constituted by using power transistors having a breakdown voltage sufficiently higher than the power source voltage V_{S}. When the breakdown voltage of the power transistor is low, a leak current of the power transistor may increase. A waveform of a motor drive voltage may become abnormal, and the transistor may be damaged.

Gate driver circuits are used to control switching operations of the high-side transistors HT_{U}, HT_{V}, and HT_{W} and the low-side transistors LT_{U}, LT_{V}, and LT_{W}. As will be described below, the gate driver circuits are integrated on the analog circuit chip 40 in the SiP 100.

A reference will be made to Fig. 2 again. The computer chip 60 in the example illustrated in Fig. 2 includes a memory 10 in which the motor control program is stored and a communication interface 12 that receives the motor control program as an electric signal from the outside. The communication interface 12 may be installed outside the computer chip 60. It is possible to rewrite the motor control program via the communication interface 12. Various motor control software programs may be written in the memory 10 in accordance with product uses. The analog circuit chip 40 generates a signal for directly or indirectly driving the transistor included in the inverter output circuit 300. An exemplary configuration of the analog circuit chip 40 will be described below.

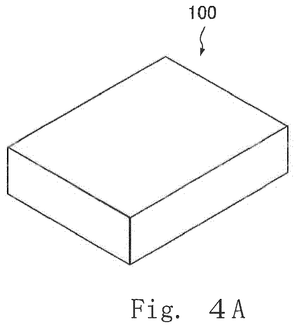

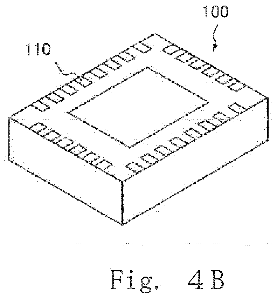

The SiP 100 includes a support 120 for installing the analog circuit chip 40 and the computer chip 60. An example of the support 120 may be a ceramic substrate or a metal base substrate. The support 120 includes a plurality of terminal electrodes 110. The analog circuit chip 40 and the computer chip 60 are fixed to the support 120 and are connected to predetermined terminal electrodes 110 inside the SiP 100. Electric connections between the terminal electrodes 110 and the respective chips 40 and 60 and an electric connection between the analog circuit chip 40 and the computer chip 60 are performed by a metal wire inside the SiP 100 such as, for example, an interconnecting line. According to the embodiment, an entirety of the interconnecting line and the chips 40 and 60 may be molded together with the support 120 by plastic. Fig. 4A is a perspective view of a top surface of the SiP 100 as viewed obliquely downward according to the present embodiment, and Fig. 4B is a perspective view of a bottom surface of the SiP 100 as viewed obliquely downward according to the present embodiment.

According to the present specification, for convenience, terminals to which the analog circuit chip 40 is connected among the plurality of terminal electrodes 110 will be referred to as a "first terminal electrode group 110A". Similarly, terminals to which the computer chip 60 is connected among the plurality of terminal electrode 110 will be referred to as a "second terminal electrode group 110B" (see Fig. 2).

A configuration of the package and the terminals is not limited to the example illustrated in the drawing. For example, various modes such as a QFP (Quad Flat Package) type, a QFN (Quad Flat No-Lead package) type, and a BGA (Ball Grid Array) type may be adopted.

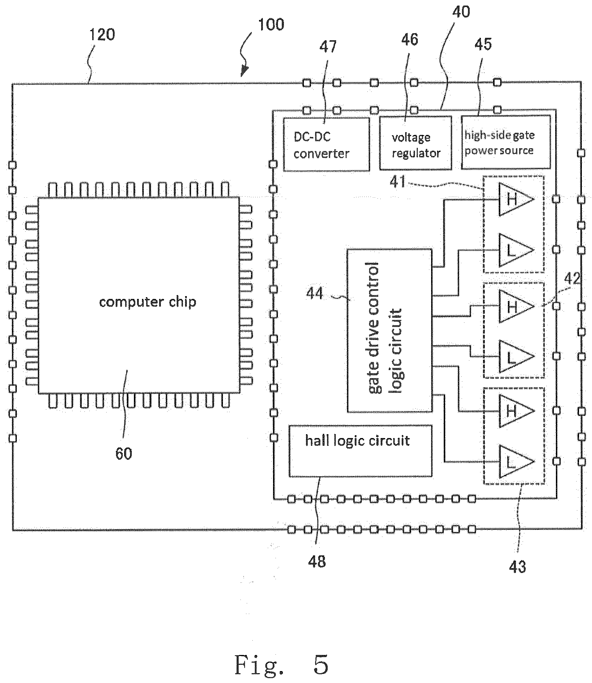

Next, a reference will be made to Fig. 5. Fig. 5 illustrates a more specific exemplary configuration of the SiP 100 according to the embodiment of the present disclosure. In Fig. 5, for simplicity, descriptions of wiring (wire bonding) inside the SiP 100 are omitted.

In the example illustrated in Fig. 5, the analog circuit chip 40 includes circuits such as gate driver circuits 41, 42, and 43, a gate drive control logic circuit 44, a high-side gate power source 45, a voltage regulator 46, a DC-DC converter 47, and a Hall logic circuit 48. The analog circuit chip 40 may include analog circuits such as an AD converter, a DA converter, a comparator, and an operational amplifier which are not illustrated in the drawings. In addition, the analog circuit chip 40 may include not only the analog circuits but also digital circuits such as the gate drive control logic circuit 44. When these circuits are integrated on a single chip, it is possible to reduce an area exclusively used for the motor drive circuit device. On the other hand, the computer chip 60 may be, for example, a general-purpose control microcontroller (micro controller).

In the example in Fig. 5, the analog circuit chip 40 and the computer chip 60 are arranged side by side on the support 120, but one of the analog circuit chip 40 and the computer chip 60 may be arranged on the other thereof. When a stack-type multichip configuration is adopted, it is possible to increase the number of chips to be mounted to two or more without increasing an area exclusively used for the SiP 100.

Fig. 5 exemplifies a general-purpose 32-bit controlling microcontroller including a central processing unit (CPU) as the computer chip 60. Such microcontroller includes a protection circuit that detects temperature, voltage, and current therein and stops operation, for example, when an abnormality is detected. When the computer chip 60 including such protection circuit and the analog circuit chip 40 are installed in the same package, an abnormal operation of the analog circuit chip 40 can also be detected, and improvement in reliability is anticipated. The computer chip 60 performs, for example, various operations necessary for the vector control on the basis of an instruction from the outside and generates a signal necessary for the motor control to be supplied to the analog circuit chip 40.

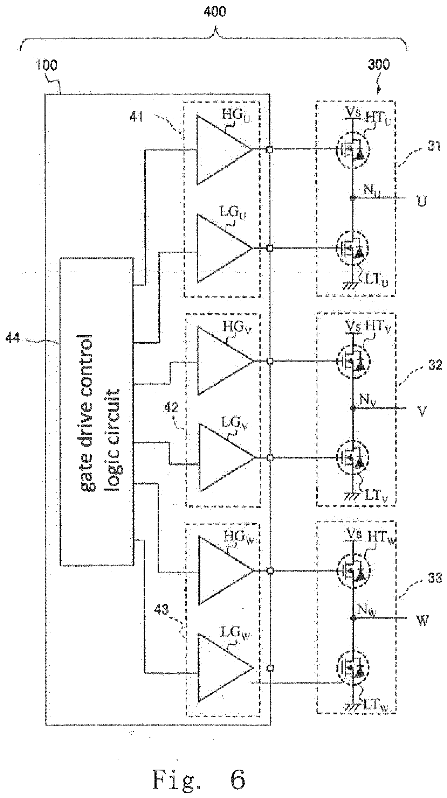

Exemplary configurations of the gate driver circuits 41, 42, and 43 will be described with reference to Fig. 6. In the motor drive circuit device 400 corresponding to the example illustrated in Fig. 6, the SiP 100 directly drives the power transistor in the inverter output circuit 300. At this time, the gate driver circuits 41, 42, and 43 in the analog circuit chip 40 respectively generate and output gate drive signals in accordance with signals output by the gate drive control logic circuit 44. Three of the gate driver circuits 41, 42, and 43 respectively correspond to the output portions 31, 32, and 33 of the U phase, the V phase, and the W phase of the inverter output circuit 300.

The gate driver circuit 41 for the U phase includes a gate driver HG_{U} that outputs a gate drive signal supplied to a gate of the high-side transistor HT_{U} and a gate driver LG_{U} that outputs a gate drive signal supplied to a gate of the low-side transistor LT_{U}. The gate driver circuit 42 for the V phase includes a gate driver HG_{V} that outputs a gate drive signal supplied to a gate of the high-side transistor HT_{V} and a gate driver LG_{V} that outputs a gate drive signal supplied to a gate of the low-side transistor LT_{V}. The gate driver circuit 43 for the W phase includes a gate driver HG_{W} that outputs a gate drive signal supplied to a gate of the high-side transistor HT_{W} and a gate driver LG_{W} that outputs a gate drive signal supplied to a gate of the low-side transistor LT_{W}. Hereinafter, in the present specification, the gate drivers HG_{U}, HG_{V}, and HG_{W} may be referred to as "high-side gate drivers", and the gate drivers LG_{U}, LG_{V}, and LG_{W} may be referred to as "low-side gate drivers" in some cases.

Exemplary internal configurations of the gate driver circuits 41, 42, and 43 will be described below. The outputs of the gate driver circuits 41, 42, and 43 change on the basis of the signals supplied from the gate drive control logic circuit 44 to the gate driver circuits 41, 42, and 43.

A reference will be made to Fig. 5 again.

The high-side gate power source 45 supplies the gate driver circuits 41, 42, and 43 with power source voltages necessary for the gate driver circuits 41, 42, and 43 to output the gate drive signals at appropriate levels in both a first mode and a second mode. The voltage regulator 46 receives the external power source and generates the power source voltage at 12 V, for example. The DC-DC converter 47 steps down the direct current voltage at 12 V obtained from the power source voltage V_{S} to 5 V or 3.3 V, for example. The thus stepped-down voltage is supplied to a circuit portion that operates at a low voltage in the analog circuit chip 40 and the computer chip 60 according to the present embodiment. The Hall logic circuit 48 synthesizes the waveforms for the three phases (U, V, W) amplified by using the operational amplifiers and passes the synthesized waveform over to the computer chip 60. It should be noted that the gate drive control logic circuit 44 operates in accordance with a control signal output by the computer chip 60 and controls the gate driver circuits 41, 42, and 43.

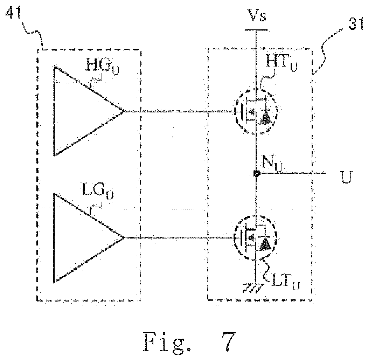

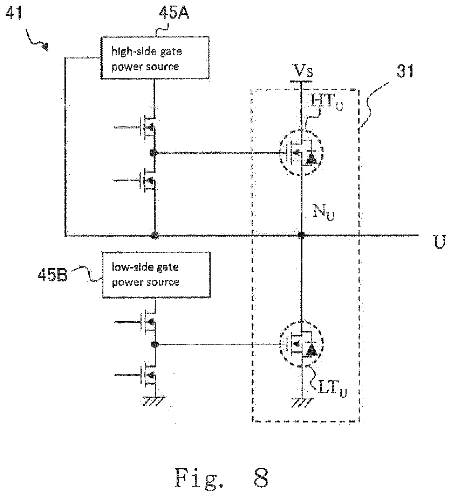

Next, generation of the gate drive signal will be described in more detail with reference to Fig. 7 and Fig. 8.

Fig. 7 extracts and describes the U-phase output portion 31 in the inverter output circuit 300 and the gate driver circuit 41. Fig. 8 is a circuit diagram describing details of the gate driver circuit 41 in Fig. 7.

As illustrated in Fig. 8, the gate driver HG_{U} in Fig. 7 includes two transistors connected in series between a high-side gate power source 45A and the node N_{U}. These two transistors have a totem-pole structure. In addition, the gate driver LG_{U} includes two transistors connected in series between a low-side gate power source 45B and ground. These two transistors also have the totem-pole structure. The two transistors constituting each totem-pole structure may also be transistors in a complementary relationship in which conductivity types are different from each other.

The high-side transistor HT_{U} and the low-side transistor LT_{U} of the U-phase output portion 31 in the inverter output circuit 300 are typically power transistors having the same gate threshold voltage. However, while the source of the low-side transistor LT_{U} is grounded, the source of the high-side transistor HT_{U} is connected to the node N_{U} indicating the motor drive voltage. As described above, the motor drive voltage rises and drops between the power source voltage V_{S} of the inverter output circuit 300 and the earth voltage. Accordingly, to turn on the high-side transistor HT_{U} and maintain its conductive state, a potential of the gate drive signal needs to exceed a gate threshold value while the potential of the node N_{U} is set as a reference. Thus, the high-side gate power source 45A has a circuit configuration in which a potential sufficiently higher than the potential of the node N_{U} is generated while the potential of the node N_{U} is set as the reference.

According to an embodiment, the low-side gate power source 45B can supply the potential at, for example, 12 V to the gate driver LG_{U} and the high-side gate power source 45A can supply the potential higher by 12 V than the potential of the node N_{U} to the gate driver HG_{U}. That is, when the potential of the node N_{U} is 50 V, for example, the high-side gate power source 45A can supply the potential (62 V) higher by 12 V than the potential of the node N_{U} to the gate driver HG_{U}. As a result, the gate drive signal output from the gate driver HG_{U} in this example shifts between 50 V (when turned off) and 62 V (when turned off).

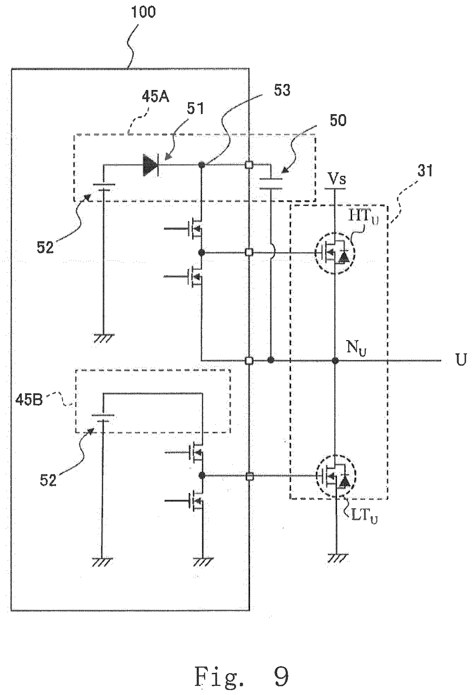

Fig. 9 is an equivalent circuit diagram illustrating exemplary configurations of the high-side gate power source 45A and the low-side gate power source 45B. The high-side gate power source 45A in this example includes a bootstrap capacitance 50 and a high breakdown voltage diode 51. The bootstrap capacitance 50 is connected between a power source node 53 of the transistor of the totem-pole structure and the node N_{U}. The high breakdown voltage diode 51 is connected between a voltage source 52 and the power source node 53. Such configuration is referred to as a so-called "bootstrap circuit". When the high-side transistor HT_{U} of the output portion 31 turns off and the low-side transistor LT_{U} turns on, that is, when the potential of the node N_{U} is at the ground level, current flows from the voltage source 52 via the high breakdown voltage diode 51 to the bootstrap capacitance 50. As a result, charges are accumulated in the bootstrap capacitance 50, and voltage equivalent to the voltage of the voltage source 52 is generated in the bootstrap capacitance 50. While the potential of the node N_{U} is set as the reference, a potential higher by the voltage equal to the voltage of the bootstrap capacitance 50 is supplied to the power source node 53.

The gate drivers HG_{V} and LG_{V} for the V phase and the gate drivers HG_{W} and LG_{W} for the W phase also have similar configurations. With regard to the high-side gate power source 45A and the low-side gate power source 45B, a single circuit may be shared by all the U, V, and W phases, or separate circuits may be prepared for the individual phases. The motor drive voltages for the respective U, V, and W phases, that is, the potentials of the nodes N_{U}, N_{V}, and N_{W} may fluctuate at mutually different times. The different high-side gate power sources 45A are respectively connected to the gate driver circuits 41, 42, and 43 according to the present embodiment, and the potentials of the nodes N_{U}, N_{V}, and N_{W} are fed back to the corresponding high-side gate power sources 45A.

It should be noted that the high breakdown voltage diode 51 may be an external element to be connected to a terminal of the SiP 100 from the outside similarly to the capacitance 50. The high breakdown voltage diode 51 according to the present embodiment is formed inside the analog circuit chip 40.

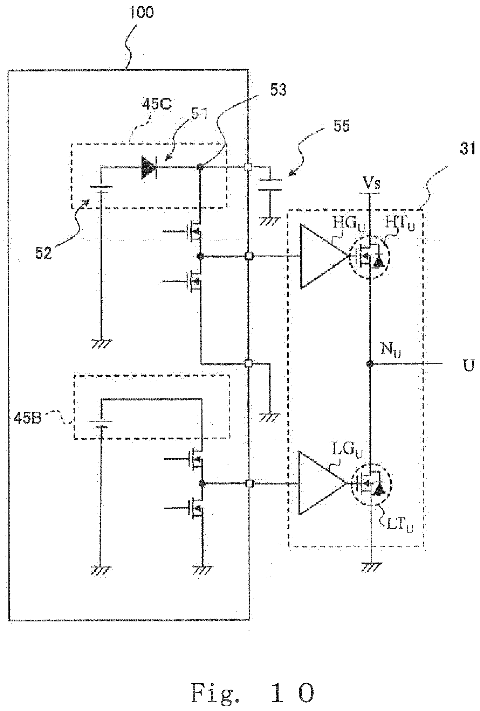

Next, a reference will be made to Fig. 10. A high-side gate power source 45C illustrated in Fig. 10 does not include a bootstrap circuit unlike the high-side gate power source 45A in Fig. 9. A capacitance 55 of the high-side gate power source 45C is not a bootstrap capacitance. The capacitance 55 is not connected to the node N_{U} but is grounded. Accordingly, a potential of the power source node 53 connected to the transistor of the totem-pole structure is held at a potential of the voltage source 52 (for example, 12 V) at all times. According to the high-side gate power source 45C of the above-mentioned configuration, the gate drive signal output from the gate driver HG_{U} for the high side shifts in a voltage range similar to that of the gate drive signal output from the gate driver LG_{U} for the low side. That is, even when the potential of the node N_{U} is 50 V, for example, the high-side gate power source 45C may supply the potential based on the voltage source 52 (for example, 12 V) to the gate driver HG_{U} irrespective of the potential of the node N_{U}. As a result, the gate drive signal output from the gate driver HG_{U} in this example shifts between 0 V (when turned off) and 12 V (when turned on), for example.

In the example illustrated in Fig. 10, the gate drive signal output from the SiP 100 is not directly input to the gates of the power transistors HT_{U} and LT_{U} of the output portion 31. The gates of the power transistors HT_{U} and LT_{U} included in the output portion 31 in Fig. 10 are connected to another gate driver circuit (which will be referred to as a "pre-driver circuit" of the inverter output circuit). Such gate driver circuit (pre-driver circuit) is configured to receive a signal in a low voltage range like 0 to 5 V or 0 to 3.3 V as a normal input, for example. Therefore, although not illustrated in Fig. 10, as will be described below, a circuit that adjusts a voltage of the signal output from the inside of the SiP 100 may be connected between the SiP 100 and the above-mentioned pre-driver circuit.

In this manner, the high-side gate power source 45C functions as a first power source connected to the high-side gate driver in a mode (first mode) in which a signal having the voltage without depending on potential changes of the connection nodes N_{U}, N_{V}, and N_{W} is output. On the other hand, the high-side gate power source 45A illustrated in Fig. 9 functions as a second power source connected to the high-side gate driver in a mode (second mode) in which a signal having the voltage with the potential changes of the connection nodes N_{U}, N_{V}, and N_{W} being set as references is output. Switching between the above-mentioned modes may be appropriately executed depending on the way of connecting the element such as, for example, the external capacitance as described with reference to Fig. 9 and Fig. 10.

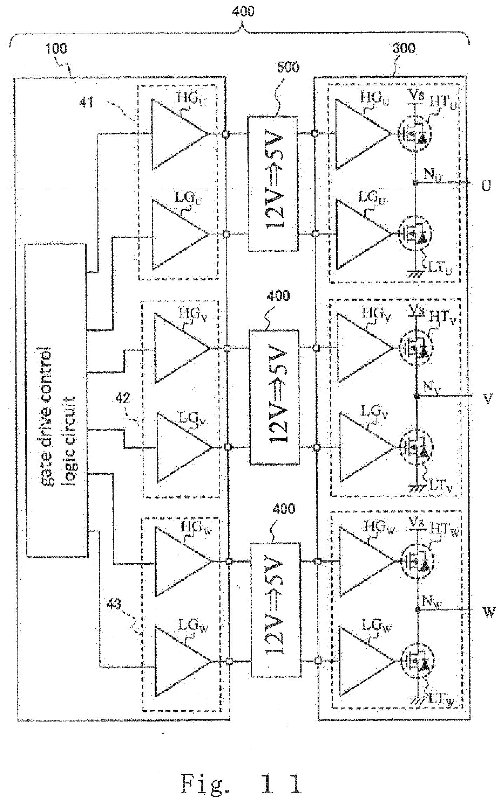

Fig. 11 illustrates an exemplary configuration (configuration for the operation by being switched into the first mode) of the motor drive circuit device 400 that uses a gate driver circuit (pre-driver circuit) different from the gate driver circuits 41, 42, and 43 incorporated in the SiP 100 to drive the gate of the inverter output circuit 300. In this example, provided is a circuit (voltage conversion circuit) 500 that decreases the voltage of the gate drive signal output from the SiP 100 to be converted to an appropriate level as an input of the gate driver of the inverter output circuit 300. This voltage conversion circuit receives the gate drive signal at, for example, 12 V from the SiP 100 to step down the gate drive signal to the gate drive signal at 5 V ("control signal" for the pre-driver circuit and input the stepped down gate drive signal to the gate driver circuit (pre-driver circuit) of the inverter output circuit 300.

In the motor drive circuit device 400 in Fig. 11, the pre-driver circuit in the inverter output circuit 300 receives the signal output from the SiP 100 as the control signal and controls switching operations of the high-side transistors HT_{U}, HT_{V}, and HT_{W} and the low-side transistors LT_{U}, LT_{V}, and LT_{W}. The pre-driver circuit in the inverter output circuit 300 has a breakdown voltage higher than the gate driver circuits 41, 42, and 43 in the SiP 100 and may be preferably used as an inverter output circuit for a motor having a large output. For a use where breakdown voltages of the gate driver circuits 41, 42, and 43 of the SiP 100 are insufficient, the configuration exemplified in Fig. 11 may be preferably adopted.

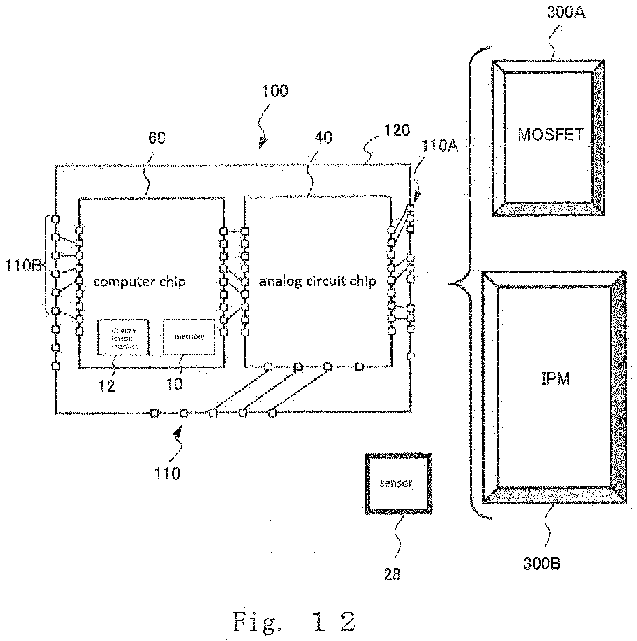

Fig. 12 schematically illustrates that the SiP 100 according to the present embodiment may be used by being connected to either one of the power modules 300A and 300B including different inverter output circuits. The power module 300A does not include the gate driver circuit like the inverter output circuit 300 illustrated in Fig. 6. In contrast to this, the power module 300B has the gate driver circuit (pre-driver) incorporated like the inverter output circuit 300 illustrated in Fig. 11. The power module 300B may be preferably used as a motor having an output larger than the motor using the power module 300A. The power module 300A is a MOSFET module. In the power module 300A, the bridge circuits of the three phases may be realized in one module, or three half bridge circuit modules may be combined and used. In addition, a circuit in which six power transistors are mounted on a substrate and mutually connected may be used. The power module 300B is typically referred to as an IPM and has a gate driver circuit having a high breakdown voltage incorporated in one module.

The SiP 100 according to the embodiment of the present disclosure operates in respectively different modes in accordance with a connection to either one of the power module 300A and the power module 300B. That is, the SiP 100 has the structure in which the first mode and the second mode can be switched. The above-mentioned mode switching is not changed depending on a manner of the connection of the external capacitance or the like, for example, but can also be realized when a switch circuit that switches between the first mode and the second mode is provided inside the SiP 100 (for example, the analog circuit chip 40). The first mode is a mode in which a potential variation range of the gate drive signal for controlling the switching operation of the high-side transistor is, irrespective of the potential of the connection node of the inverter output circuit 300, set to be the same as a potential variation range of the gate drive signal for controlling the switching operation of the low-side transistor. The second mode is a mode in which the potential variation range of the gate drive signal for controlling the switching operation of the high-side transistor is changed in accordance with the potential of the connection node of the inverter output circuit 300. According to this, the power transistor of the inverter output circuit 300 can also be driven by using the gate driver circuit included in the analog circuit chip, and in addition, it becomes possible to adopt another gate driver circuit of a higher breakdown voltage in accordance with the motor output without being restricted to the gate driver circuit included in the analog circuit chip.

In general, in a case where the motor output is large, a breakdown voltage may be insufficient with the gate driver circuit in the SiP 100. According to the embodiment of the present disclosure, since another gate driver circuit having a high breakdown voltage can be used, high versatility can be realized.

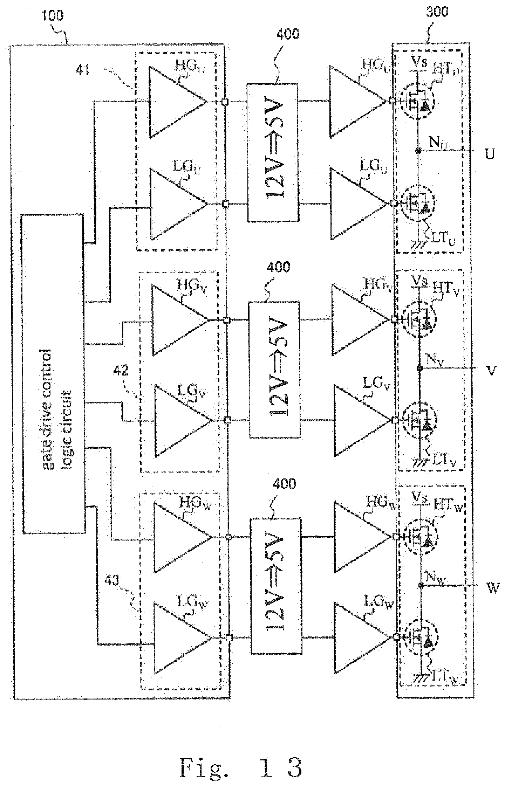

It should be noted that, even in a case where the power module 300A that does not have the gate driver circuit incorporated therein is used, the power module 300B may be driven by using the gate driver circuit other than the gate driver circuit in the SiP 100. Fig. 13 illustrates such example.

According to the embodiment of the present disclosure, a single SiP 100 can be used in a mode illustrated in Fig. 13 or can also be used in a mode illustrated in Fig. 6. In the mode illustrated in Fig. 13, the potential variation range of the gate drive signal for controlling the switching operation of the high-side transistor does not depend on the potentials of the connection nodes N_{U}, N_{V}, and N_{W} of the inverter output circuit 300. The potential variation range of the gate drive signal for controlling the switching operation of the high-side transistor in this mode is set as the same range as the potential variation range of the gate drive signal for controlling the switching operation of the low-side transistor (first mode). On the other hand, in the mode illustrated in Fig. 6, the potential variation range of the gate drive signal for controlling the switching operation of the high-side transistor changes in accordance with the potentials of the connection nodes N_{U}, N_{V}, and N_{W} of the inverter output circuit 300 (second mode).

In this manner, the SiP 100 according to the embodiment of the present disclosure has the structure in which the operations can be switched between the first mode and second mode which are different from each other. More specifically, as illustrated in Fig. 9 and Fig. 10, the SiP 100 includes the high-side gate power source 45 that can change the voltages supplied to the gate drivers 41, 42, and 43 for the high side in accordance with whether or not the external bootstrap capacitance 50 is connected.

The high-side gate power source 45 is not limited to one having the configurations illustrated in Fig. 9 or Fig. 10. The high-side gate power source 45 may be a charge pump circuit. It is sufficient when the charge pump circuit has a known configuration. The charge pump circuit includes an oscillating circuit and a switching circuit and typically accumulates charges in an external capacitor. The charge pump circuit is a circuit that obtains an output voltage by superimposing a voltage charged in the capacitor and an input voltage on each other. The charge pump circuit can also add a necessary voltage to the potentials of the connection nodes N_{U}, N_{V}, and N_{W} to be supplied to the transistor of the totem-pole structure.

In this manner, the SiP according to the embodiment of the present disclosure can switch between the first mode in which the potential variation range of the gate drive signal for controlling the switching operation of the high-side transistor in the inverter output circuit 300 is set as the same range as the potential variation range of the gate drive signal for controlling the switching operation of the low-side transistor and the second mode in which the potential variation range of the gate drive signal for controlling the switching operation of the high-side transistor changes in accordance with the potentials of the connection nodes N_{U}, N_{V}, and N_{W} of the inverter output circuit 300.

In the first mode, the high-side gate driver and the low-side gate driver may operate by being connected to the same power source (first power source). However, in the second mode, a circuit such as the bootstrap circuit or the charge pump circuit functions as the power source and supplies the necessary voltage to the high-side gate driver. As a result, the high-side gate driver in the second mode can receive the potential obtained by adding the voltage necessary for the switching to the potentials of the connection nodes N_{U}, N_{V}, and N_{W} and operate.

The above-mentioned mode switching can be realized without changing the circuit configuration in the SiP 100. In the example described above, the mode can be switched on the basis of whether or not the bootstrap circuit is realized by the connection of the external capacitance. In a case where at least part of the charge pump circuit (for example, the oscillating circuit and the switching circuit) is integrated in the analog circuit chip, it is sufficient when a terminal for controlling whether or not the oscillating circuit is enabled (effective) is provided, for example.

As described above, according to the embodiment of the present disclosure, in a case where the motor for a special use (high breakdown voltage and high output) is used, even when an external IPM becomes necessary, the connection to the IPM can be performed by adjusting the output of the gate driver circuit in the SiP 100.

When the SiP according to the embodiment of the present disclosure is used, it becomes possible to reduce the size of the mounting substrate, realize simplification of the circuit configuration, and improve design efficiency. With regard to differences in motor control techniques based on various requests, it becomes possible to cope with such differences by changing program, for example. Thus, improvement in performance and cost reduction are anticipated. In addition, the respective electronic parts need to be connected by copper foil wires of a substrate pattern in the configuration according to the related art, but according to the present embodiment, such wires become unnecessary. That is, since it is possible to reduce the wires to the necessary minimum, a wiring length is shortened. As a result, improvement in noise resistance performance is also anticipated. Furthermore, reliability may be improved by functions of detecting temperature, voltage, and current intrinsically included in a high performance microcomputer which may be used as a computer chip.

Since the manufacturing costs are realized according to the SiP in the present disclosure, it also becomes possible to achieve improvement in quietness by applying the vector control also to the electric equipment that could not execute the advanced vector control from the viewpoint of costs. For example, a motor for small-sized equipment such as a dryer is caused to smoothly rotate, and thereby it becomes possible to reduce the sound at the time of the operation.

The embodiment of the present disclosure may be widely used for various types of equipment including various motors such as a vacuum cleaner, a dryer, a ceiling fan, a washing machine, and a refrigerator.

### Reference Signs List

20 CONTROL MICROCONTROLLER, 22 MOTOR DRIVE IC, 24 OPERATIONAL AMPLIFIER, 26 DC-DC CONVERTER, 28 SENSOR SUCH AS HALL IC, 30 POWER TRANSISTOR UNIT, 31, 32, 33 INVERTER OUTPUT CIRCUIT OUTPUT PORTION, 40 ANALOG CIRCUIT CHIP, 41, 42, 43 GATE DRIVER CIRCUIT, 44 GATE DRIVE CONTROL LOGIC CIRCUIT, 45, 45A, 45C HIGH-SIDE GATE POWER SOURCE, 45B LOW-SIDE GATE POWER SOURCE, 46 VOLTAGE REGULATOR, 47 DC-DC CONVERTER, 48 HALL LOGIC CIRCUIT, 50 BOOTSTRAP CAPACITANCE, 51 HIGH BREAKDOWN VOLTAGE DIODE, 52 VOLTAGE SOURCE, 53 POWER SOURCE NODE, 55 CAPACITANCE, 60 COMPUTER CHIP, 80 CURRENT SENSOR, 100 SYSTEM IN PACKAGE (SiP), 110 TERMINAL ELECTRODE, 110A FIRST TERMINAL ELECTRODE GROUP, 110B SECOND TERMINAL ELECTRODE GROUP, 120 SUPPORT, 200 MOTOR, 300 INVERTER OUTPUT CIRCUIT, 300A, 300B POWER MODULE (INCORPORATED IN INVERTER OUTPUT CIRCUIT), 400 MOTOR DRIVE CIRCUIT DEVICE, 500 VOLTAGE CONVERSION CIRCUIT, HT_{U}, HT_{V}, HT_{W} HIGH-SIDE TRANSISTOR, LT_{U}, LT_{V}, LT_{W} LOW-SIDE TRANSISTOR, N_{U}, N_{V}, N_{W} CONNECTION NODE BETWEEN HIGH-SIDE TRANSISTOR AND LOW-SIDE TRANSISTOR, HG_{U}, HG_{V}, HG_{W} HIGH-SIDE GATE DRIVER, LG_{U}, LG_{V}, LG_{W} LOW-SIDE GATE DRIVER

## Claims

1. A system in package usable by being connected to an inverter output circuit that includes plural pairs each including a high-side transistor and a low-side transistor connected in series and generates motor drive voltages of a plurality of phases each of which is generated from a connection node between the high-side transistor and the low-side transistor in a corresponding pair, the system in package comprising:
a support including a plurality of terminal electrodes;
an analog circuit chip that is electrically connected to a first terminal electrode group included in the plurality of terminal electrodes and includes a plurality of gate driver circuits that output gate drive signals for controlling respective switching operations of the high-side transistors and the low-side transistors to any one of the terminal electrodes of the first terminal electrode group; and
a computer chip that is electrically connected to a second terminal electrode group included in the plurality of terminal electrodes and the analog circuit chip and includes a memory in which a motor control program is stored,
wherein switching between a first mode and a second mode is performed,
the first mode being a mode in which a potential variation range of the gate drive signal for controlling the switching operation of the high-side transistor is set to be identical to a potential variation range of the gate drive signal for controlling the switching operation of the low-side transistor irrespective of a potential of the connection node of the inverter output circuit,
the second mode being a mode in which the potential variation range of the gate drive signal for controlling the switching operation of the high-side transistor is changed in accordance with the potential of the connection node of the inverter output circuit.

2. The system in package according to Claim 1, further comprising a switch circuit that switches between the first mode and the second mode.

3. The system in package according to Claim 2,
wherein each of the plurality of gate driver circuits in the analog circuit chip includes
a high-side gate driver connected to a gate of the high-side transistor and a low-side gate driver connected to a gate of the low-side transistor,
wherein the analog circuit chip includes a first power source connected to the high-side gate driver in the first mode, and
a second power source connected to the high-side gate driver in the second mode, and
wherein a selected one of the first and second power sources by the switching circuit is connected to the high-side gate driver.

4. The system in package according to Claim 3, wherein the second power source includes at least part of a charge pump circuit or at least part of a bootstrap circuit.

5. The system in package according to any one of Claims 1 to 4, further comprising a communication circuit that is connected to any one of the plurality of terminal electrodes, receives the motor control program from outside, and stores the motor control program in the memory.

6. A motor drive circuit device comprising:
an inverter output circuit that includes plural pairs each including a high-side transistor and a low-side transistor connected in series and generates motor drive voltages of a plurality of phases each of which is generated from a connection node between the high-side transistor and the low-side transistor in a corresponding pair; and
a system in package that outputs gate drive signals for controlling respective switching operations of the high-side transistor and the low-side transistor,
wherein the system in package is the system in package according to any one of Claims 1 to 5.

7. The motor drive circuit device according to Claim 6,
wherein a potential variation range of the gate drive signal for controlling the switching operation of the high-side transistor is set to be identical to a potential variation range of the gate drive signal for controlling the switching operation of the low-side transistor irrespective of a potential of the connection node of the inverter output circuit,
wherein the inverter output circuit includes a pre-driver circuit that generates signals for controlling the respective switching operations of the high-side transistor and the low-side transistor in response to a control signal and that inputs the generated signals to the high-side transistor and the low-side transistor, and
wherein the motor drive circuit device further comprises a circuit that receives and steps down the gate drive signal output from the gate driver circuit of the analog circuit chip included in the system in package to be converted into the control signal and input to the pre-driver circuit.

8. A motor module comprising:
the motor drive circuit device according to Claim 6 or 7; and
a motor connected to the motor drive circuit device.
